# EUROPEAN PATENT APPLICATION

(11) **EP 1 863 156 A1**
(43) Date of publication of application: **05.12.2007**
(21) Application number: 05721488.4
(22) Date of filing: 25.03.2005
(51) Int. Cl.: H02M 1/00

(54) **POWER CONVERTER COOLING STRUCTURE**

(71) Applicant: MITSUBISHI DENKI KABUSHIKI KAISHA, Chiyoda-ku, Tokyo 100-8310 (JP)
(72) Inventor: KOBAYASHI, Tomohiro, c/o Mitsubishi Denki K.K., Tokyo 100-8310 (JP)
(74) Representative: Sajda, Wolf E.
(86) International application number: PCT/JP2005/005561
(87) International publication number: WO 2006/103721

(57) **Abstract**

To obtain a cooling structure capable of efficiently cooling both a power semiconductor element (1) and a smoothing capacitor (2) of a power conversion equipment, a plurality of power semiconductor elements (1) are connected adjacent to one side of the smoothing capacitor (2) to form a group (3); plural numbers of groups (3a to 3c) are located in a line on a cooling plate (5) so that the power semiconductor elements (1) and the smoothing capacitors (2) are alternately aligned; and a refrigerant channel (6) through which refrigerant for cooling the power semiconductor (1) and the smoothing capacitor (2) flows is provided in the cooling plate (5) immediately below the power semiconductor element (1).

## Description

### Technical Field

The present invention relates to a cooling structure of a power conversion equipment using a power semiconductor element and a smoothing capacitor.

### Background Art

As to a conventional cooling structure of power conversion equipment, for example, in Patent Document 1, the following art is disclosed as a method of heat radiation of an inverter power supply unit. That is, there is formed a step projecting from the central portion of the bottom of a case in which the inverter power supply unit is contained, and passages of a cooling fluid are formed in the step. A converter module and an inverter module are mounted and attached on the top face of the step. To the converter module, a smoothing capacitor is connected via a copper bar, and a choke coil is connected via a terminal respectively; and to the inverter module, an electrolytic capacitor is connected via a copper bar.
The smoothing capacitor, the choke coil, and the electrolytic capacitor are fixed in the state in which respective sides thereof are adjacent to the faces of height of the step, and respective bottom faces thereof are adjacent to the support surface of the case. Further, height of the step is set so that the connection surfaces are of even height (refer to Patent Document 1).

Patent Document 1: Japanese Patent Publication (unexamined) No. 243 865/2003 (on page 3, Fig. 1)

### Disclosure of Invention

According to Patent Document 1, the power semiconductor element that is formed of an inverter module and a converter module is constructed to be in one group, and positioned one step higher at the central portion of the case; and the smoothing capacitor and the electrolytic capacitor are located adjacent to one side face of this step, and the choke coil is located adjacent to the other side face. Accordingly, both the capacitors and the choke coil are cooled mainly at the side faces adjacent to the side faces of the step.
In the case where downsizing or the use under high-temperature environments is required as is a power conversion equipment to be applied to, for example, automobiles, the temperature rise due to heat generation of the capacitors is not ignorable, thus enough cooling thereof coming to be very important. In the cooling structure according to the conventional case construction as described above, only faces adjacent to the side faces of the step are mainly cooled. Consequently, a problem exits in that electronic components such as capacitors disposed at the step height portion become insufficient in cooling capacity in the case where downsizing or the use under high-temperature environments is required.

The present invention was made to solve the above-described problem, and has an object of obtaining a cooling structure of a power conversion equipment capable of efficiently cooling both a power semiconductor element and a smoothing capacitor by minimizing a refrigerant flow rate or a pressure drop with simple refrigerant channels.

A cooling structure of a power conversion equipment according to the invention includes a power semiconductor element and a smoothing capacitor, and makes power conversion from DC to AC, or from AC to DC, the cooling structure of a power conversion unit being constructed such that the power semiconductor element is connected adjacent to one side of the smoothing capacitor to form a group; plural numbers of the groups are located on a cooling plate so that the power semiconductor elements and the smoothing capacitors are alternately aligned; and a refrigerant channel for cooling the power semiconductor element and the smoothing capacitor is provided in the cooling plate immediately below the power semiconductor element.

According to the cooling structure of a power conversion equipment of the invention, plural numbers of groups including the power semiconductor elements and the smoothing capacitors are located on a cooling plate so that the power semiconductor elements and the smoothing capacitors are alternately aligned, and the refrigerant channels are provided in the cooling plate immediately below the power semiconductor elements.
As a result, the power semiconductor elements are cooled with the refrigerant channels formed immediately below thereof, and the smoothing capacitors, which are sandwiched between the power semiconductor elements and of which heat is hard to be radiated, are cooled from both sides with the refrigerant channels immediately below the power semiconductor elements on both sides thereof, it is possible to efficiently cool both the power semiconductor elements and the smoothing capacitors with the refrigerant channels of simple construction.

### Best Mode for Carrying Out the Invention

### Embodiment 1.

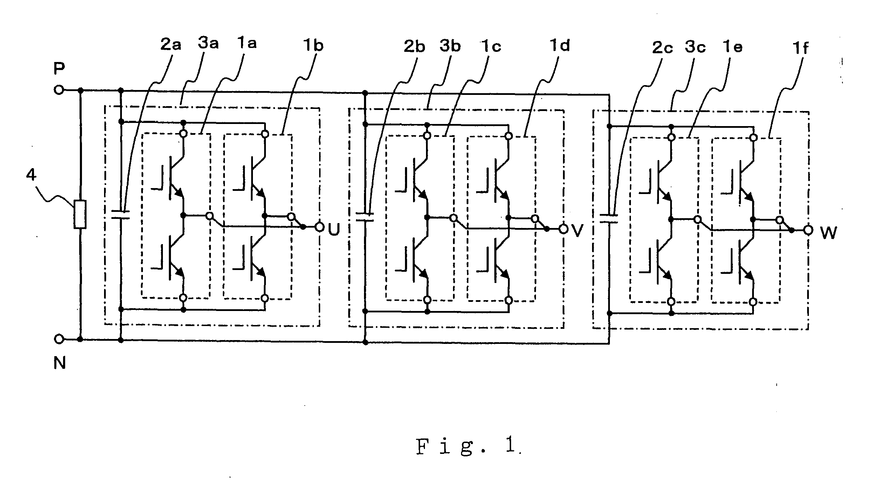

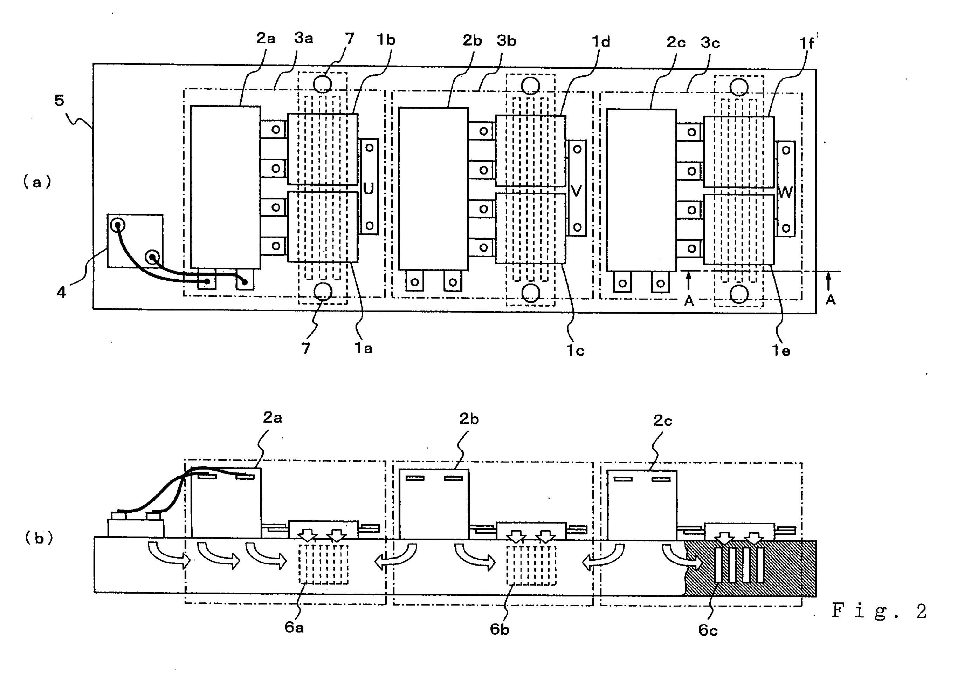

Fig. 1 is a schematic circuit diagram of power conversion equipment according to a first preferred embodiment. Fig. 2 shows structural diagrams, and in which Fig. 2(a) is a plan view, and Fig. 2(b) is a front view showing a part taken along the line A-A indicated by arrows in Fig. 2(a) as the partial cross section.
First, with reference to Fig. 1, the circuit arrangement is explained. Additionally, Fig. 1 shows an example of an inverter of three phases as a power conversion equipment.
Power semiconductor elements 1a to 1f forming an inverter are packaged by connecting in series switching elements that are, for example, IGBT. Plural numbers of these power semiconductor elements are connected in parallel depending on the capacity to be used. According to this first embodiment, shown is the case where two power semiconductor elements are connected in parallel in one phase. For example, in regard to U phase, the power semiconductor elements 1a and 1b are connected in parallel, and a smoothing capacitor 2a is connected in parallel to these power semiconductor elements 1a and 1b to form one group 3a. Further, three phases of groups 3a to 3c are connected in parallel to DC input terminals P and N.

In addition, a discharging resistor 4 is connected to the DC input terminals P and N, so as to act to discharge an electric power having been charged in the smoothing capacitors 2a and 2c when an inverter is stopped. A three-phase AC is controlled to be output from AC output terminals U, V, and W of respective groups 3a to 3c to be used as, for example, a drive power supply of an electric motor of automobiles or vehicles.

Now, the structure is described with reference to Fig. 2. To explain with the U-phase section, two numbers of power semiconductor elements 1a and 1b are located side-by-side adjacent to one side of the smoothing capacitor 2a respectively. At this time, to cause wiring to be the shortest, two power semiconductor elements 1a and 1b are disposed along the longitudinal direction of the smoothing capacitor 2a, and connected in the proximity to form the group 3a. Likewise, the power semiconductor elements 1c and d and the smoothing capacitor 2b form a V-phase of group 3b, and the power semiconductor elements 1e and 1f and the smoothing capacitor 2c form a W-phase of group 3c.
These groups 3a to 3c are located on a cooling plate 5 such that the power semiconductor elements and the smoothing capacitors are alternately aligned, that is, respective groups are aligned in a line faced in the same direction as shown in Fig. 2 to be fixed. Moreover, a discharging resistor 4 is disposed on the immediate left of the U-phase of smoothing capacitor 2a, and connected in parallel to the smoothing capacitor 2a.

Additionally, in the following descriptions, subscripts of reference numerals with alphabetical subscripts such as the power semiconductor elements 1a to 1b are omitted in the case of making the description as a whole, and simple indication, for example, a power semiconductor element 1 is made.

The cooling plate 5 serves to fix electronic components to be mounted, as well as to radiate heat to be generated from the electronic components, so that it is made of, e.g., aluminum having high thermal conductivity. A cooling channel 6 is formed in the cooling plate 5 in a direction from the front side to the back side, being an alignment direction of the elements in each phase at a position immediately below the power semiconductor element 1 in order to achieve further cooling.
As shown in the cross sectional view of the front elevation of Fig. 2(b), the cross sectional shape of the refrigerant channel 6 is formed to have a shape of a plurality of rectangular-shaped holes being aligned for the purpose of making a surface area larger. Although refrigerant openings 7 functioning as an inlet or outlet of the refrigerant channel 6 are provided at the top of the cooling plate 5 in the drawing, it is preferable if they are formed on the front side and on the back side of the cooling plate 5. As a refrigerant, for example, water in which an anti-freeze solution is mixed is used.
Additionally, with reference to Fig. 2, the connection of the entire refrigerant channels and the connection of DC input between the groups are omitted. Further, parts having no direct relation to the technique according to the invention such as a case covering the entire power conversion equipment or control section are also omitted.

Now, operations are described referring to Figs. 1 and 2. A DC power having been input from the DC input terminals P and N, is output from AC output terminals U, V, W by the ON/OFF operation of each power semiconductor element 1 after passing through the smoothing capacitor 2, and supplied to loads (not shown) as an AC power. At this time, each power semiconductor element 1 generates loss. Furthermore, each smoothing capacitor 2 also generates loss.
Depending on the capacity, heat loss of the power semiconductor element 1 is, for example, as much as approximately several kW, and the temperature at the contact surface with the cooling plate 5 rises to about 90° C. Heat loss of the smoothing capacitor 2 is low, being approximately several Watt as compared with that of the power semiconductor element 1.
However, the surface temperature also rises much, and there are some cases in which the temperature at the contact surface with the cooling plate 5 goes up to the extent of, for example, about 85° C. Since a smoothing capacitor 2 may be made of material easily affected by high temperature, or may have restrictions on an allowable ripple current depending on the temperature, it is necessary to take a thorough consideration with respect to cooling.

Thus, according to the first embodiment of the invention, a power semiconductor element 1 is arranged to be efficiently cooled with a refrigerant flowing through the refrigerant channels 6 that are located immediately below. Furthermore, a smoothing capacitor 2 is arranged to transfer heat to the cooling plate 5 to be cooled with the refrigerant flowing through the refrigerant channels 6 disposed immediately below.
In particular in a smoothing capacitor 2 that is located in a sandwiched manner between the power semiconductor elements 1 out of the smoothing capacitors 2, heat is persisting internally to bring about thermally difficult conditions. However, the power semiconductor elements 1 and the smoothing capacitors 2 are located so as to be alternately aligned, and the refrigerant channels 6 are formed immediately below the power semiconductor element 1, so that heat having been transferred from the smoothing capacitor 2 to the cooling plate 5 is transferred to the refrigerant channels 6 divided into both sides, and cooled as indicated by the thick arrows in Fig. 2(b).
For example, the smoothing capacitor 2c is cooled with the refrigerant flowing through the proximal refrigerant channels 6band 6c. In addition, the smoothing capacitor 2a of U phase that is positioned at the left end in the drawing is cooled only with the refrigerant channel 6a on one side. However, the power semiconductor elements 1a and 1b are located only on one side, so that the smoothing capacitor 2a is under less thermally difficult conditions than the smoothing capacitors 2b and 2c sandwiched between the power semiconductor elements on both sides.
Although the discharging resistor 4 also generates heat, this heat is transferred to the cooling plate 5 to be cooled with the refrigerant channel 6a closest thereto.

As described above, according to this first embodiment of the invention, several numbers of groups including power semiconductor elements and smoothing capacitors are located on a cooling plate so that the power semiconductor elements and the smoothing capacitors are alternately aligned; and a refrigerant channel is provided in the cooling plate immediately below the power semiconductor element.
As a result, the power semiconductor elements are cooled with the refrigerant channels formed immediately below thereof, and the smoothing capacitors, which are sandwiched between the power semiconductor elements, and the heat of which is hard to radiate, are cooled from both sides with the refrigerant channels immediately below the power semiconductor elements on both sides thereof; so that it is possible to efficiently cool both the power semiconductor element and the smoothing capacitor in a simple construction having a small pressure drop without forming the special refrigerant channels for the smoothing capacitors.
Furthermore, each group is formed of power semiconductor elements and a smoothing capacitor, so that the groups are located being aligned at regular intervals in a planar manner, resulting in a construction of superior workability at the time of assembly, and easy removal of refrigerant piping. Further, it is possible to obtain a power conversion equipment capable of easily achieving a mounting design having a high degree of flexibility in accordance with the increase or decrease of a capacity.

### Embodiment 2

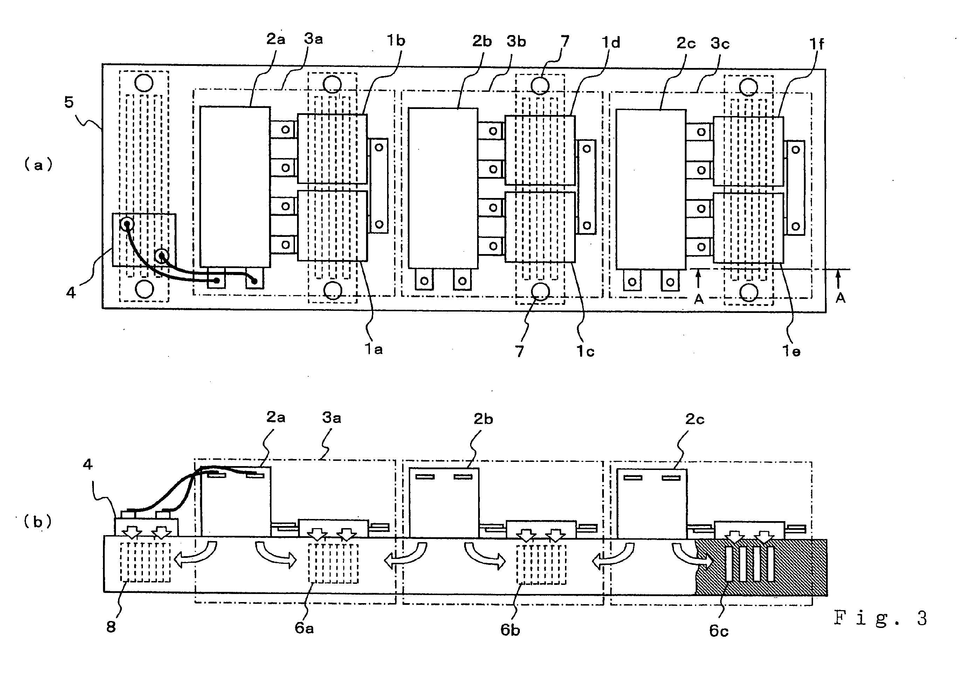

Fig. 3 shows structural diagrams of power conversion equipment according a second embodiment. Fig. 3(a) shows a plan view. Fig. 3(b) is a front view showing a part taken along the line A-A indicated by the arrows of Fig. 3 (a) as a partial cross section. The same reference numerals indicate like parts to those of Fig. 2 according to the first embodiment, and description thereof will be omitted. Further, a circuit diagram of the power conversion equipment is the same as that in Fig. 1 according to the first embodiment. Descriptions are made with reference to Fig. 3 with a focus on points different from the first embodiment.

In the same manner as in Fig. 2 showing the first embodiment, three groups that are formed of power semiconductor elements 1 and smoothing capacitors 2 are located on the cooling plate 5 so that the power semiconductor elements 1 and the smoothing capacitors 2 are alternately aligned side-by-side. The point different from Fig. 2 is that an auxiliary refrigerant channel 8 is provided in the cooling plate 5 on the opposite side to the power semiconductor elements 1a and 1b of an end group 3a on the side of a smoothing capacitor 2 being the very end out of several numbers of three groups, that is, a U-phase of group 3a in the case of Fig. 3, in the vicinity of the smoothing capacitor 2a of this end of group 3a.
The discharging resistor 4 is located right above the foregoing auxiliary refrigerant channel 8. Supposing that the auxiliary refrigerant channel 8 is formed to be the same as the other refrigerant channels 6a to 6c in the aspect of cross sectional shape and channel direction, it is possible that the auxiliary refrigerant channel 8 is likewise provided by machining, resulting in an easy manufacture.

Now, the operation will be described. The thick arrows in Fig. 3(b) indicate heat transfer channels of each part. The auxiliary refrigerant channel 8 serves to cool the discharging resistor 4 located right above the auxiliary refrigerant channel 8, as well as to cool one side of a U-phase of the smoothing capacitor 2a. As a result, there are provided refrigerant channels on both sides of all the smoothing capacitors 2. Accordingly, it is possible to cool all the smoothing capacitors 2a to 2c substantially equally from both sides thereof via the cooling plate 5.

As described above, according to the second embodiment of the invention, in the vicinity of a smoothing capacitor of the end group, which is positioned at the end of plural numbers of groups, and in which this smoothing capacitor is at the very end, an auxiliary refrigerant channel is provided in the cooling plate positioned on the outside thereof.
As a result, it is possible to cool all the smoothing capacitors from both sides through the cooling plate, thus enabling to obtaining power conversion equipment having small fluctuation in cooling capacity between the groups, and high cooling efficiency. Further, it is possible to cool electronic components such as a discharging resistor, being a heating element, with an auxiliary refrigerant channel.

### Embodiment 3

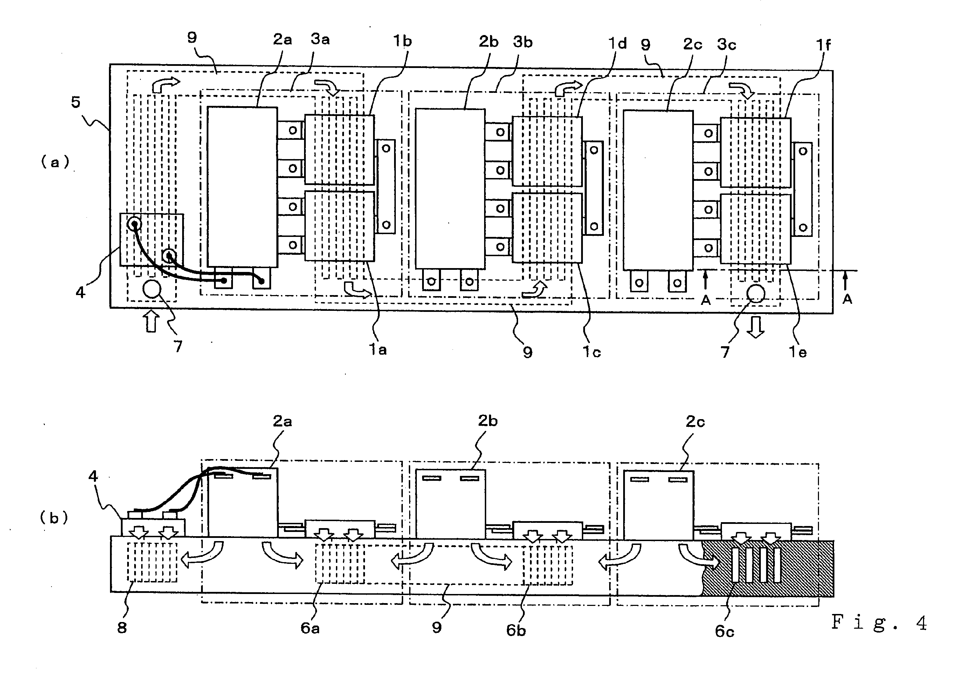

Fig. 4 is a structural diagram of power conversion equipment according to a third embodiment. Fig. 4(a) shows a plan view. Fig. 4(b) is a front view showing a part taken along the line A-A indicated by the arrows of Fig. 4(a) as a partial cross section. The same reference numerals indicate like parts to those in Figs. 3 according to the second embodiment, and description thereof will be omitted. Further, a circuit diagram of the power conversion equipment is the same as that in Fig. 1 according to the first embodiment. Descriptions are made referring to Fig. 4 with a focus on points different from the second embodiment.

The fact that the power semiconductor elements 1 and smoothing capacitors 2 are alternately located on a cooling plate 5 is the same as in the first and second embodiments. Further, the point that refrigerant channels and an auxiliary refrigerant channel 8 are formed immediately below the power semiconductor element 1 and in the vicinity of outside of the smoothing capacitor 2a of the end group 3a respectively is the same as in the second embodiment 2.
A point different from the second embodiment is that a connection channel 9 functioning to provide the connection between each of the refrigerant channels 6a to 6c and the auxiliary refrigerant channel 8 is provided in the cooling plate 5 in order to combine the entirety of channels into one series passage.

As a result of such a construction, passages of the refrigerant are formed as indicated by the thick arrows in Fig. 4(a), and the refrigerant which has flown in from one refrigerant opening 7 cools the discharging resistor 4 and the power semiconductor element 1 and smoothing capacitor 2 of each group to flow out from the other refrigerant opening 7. At this time, supposing that a three-phase output inverter consists of an odd number of groups letting one phase of the three-phase output inverter one group, and an auxiliary refrigerant channel is provided at one end, it comes to be possible to form the refrigerant opening 7 on one side of the cooling plate 5 as shown in the drawing.

As described above, according to this third embodiment of the invention, there is formed in the cooling plate a connection channel for providing the series connection of one passage between the refrigerant channels and the auxiliary refrigerant channel. As a result, in addition to the advantages of the first and second embodiments, it is possible to make a simple connection of input/output of a refrigerant with respect to power conversion equipment.
In particular, in case of an even number of refrigerant channels (adding an auxiliary refrigerant channel thereto), it is possible that a refrigerant opening is located on one side of the equipment, resulting in a further simple connection from outside.

### Embodiment 4

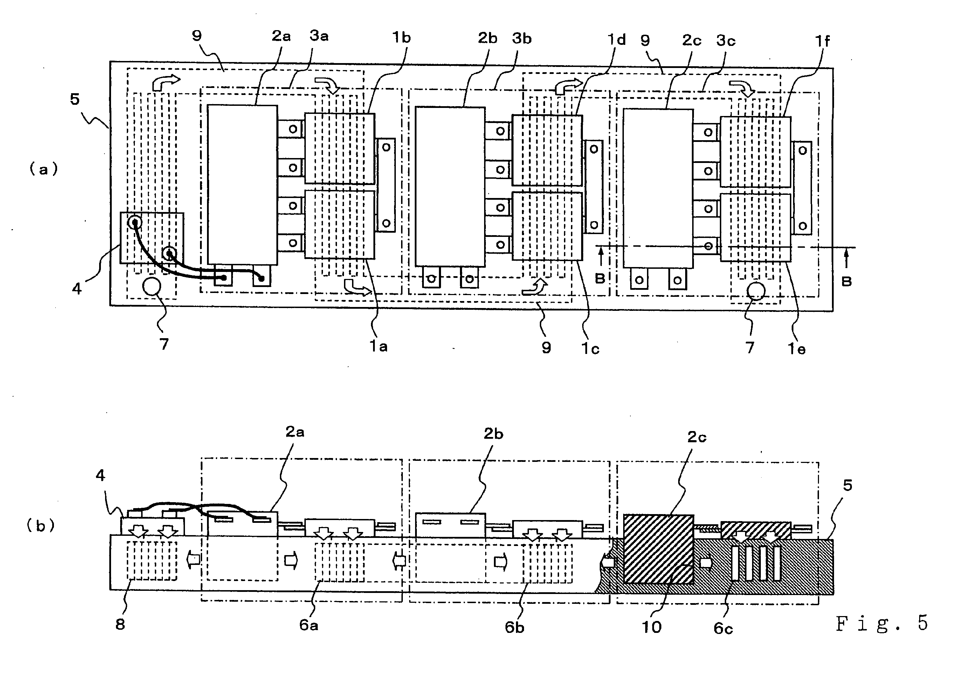

Fig. 5 shows structural diagrams of power conversion equipment according a fourth embodiment. Fig. 5(a) is a plan view. Fig. 5(b) is a front view showing the part taken along the line B-B indicated by the arrows of Fig. 5(a) as a partial cross section. The reference numerals indicate like parts to those in Figs. 4 according to the third embodiment, and descriptions thereof will be omitted. Further, a circuit diagram of the power conversion equipment is the same as that in Fig. 1 according to the first embodiment. Descriptions are made referring to Fig. 5 with a focus on points different from the third embodiment.

The power conversion equipment according to this fourth embodiment is constructed, as shown in the cross sectional view of Fig. 5(b), such that smoothing capacitors 2 are fitted in concave parts 10 that are formed in the cooling plate 5 in conformity with the configuration of the smoothing capacitors 2 to be fixed; and in this point, the power conversion equipment according to the fourth embodiment is different from that according to the third embodiment.
As a result of such construction, the smoothing capacitors 2 are in contact with the cooling plate 5 at the bottom face and at the side faces, so that the contact area becomes larger. In addition to this increase in contact area, as shown with thick arrows of Fig. 5(b), a length of heat transfer channels from the smoothing capacitors 2 to the refrigerant channels 6 (or the auxiliary refrigerant channel 8) comes to be smaller, resulting in a larger cooling effect of the smoothing capacitors 2.

In general, the height of a smoothing capacitor 2 is larger than the length of a power semiconductor element 1. The smoothing capacitors 2 shown in the first to third embodiments are constructed such that terminals of the smoothing capacitor 2 and the power semiconductor 1 are so high as to be connected to each other as they are when the smoothing capacitors 2 and the power semiconductors 1 are mounted onto the cooling plate 5.
In practical use, however, there are many cases in which heights of the terminals are different. Even in this case, by adjusting the depth of engraving of the concave parts 10 provided in the cooling plate 5, it is possible to make even the heights of terminals of the power semiconductor element 1 and the smoothing capacitor 2, thus enabling to cause the connection length of conductors to be the shortest.

In addition, although the refrigerant channel of Fig. 5 is shown to connect in series in the same manner as in the third embodiment, it is preferable to be individually independent of each other as in the case of the first or second embodiment.

As described above, according to the fourth embodiment of the invention, the smoothing capacitor is fitted and fixed in a concave part formed in the cooling plate in conformity with the configuration of the smoothing capacitor. As a result, since the contact area of the smoothing capacitors and the cooling plate is increased, as well as the heat transfer passage to the refrigerant channels becomes shorter, it is possible to achieve a larger cooling effect of the smoothing capacitors.
In addition, by fitting the bottom of a smoothing capacitor, which is generally higher than a power semiconductor element, in the cooling plate to adjust the position in height direction, it is possible to bring the height of terminals of a smoothing capacitor close to the height of terminals of a power semiconductor element, and to decrease the wiring inductance between the power semiconductor elements and the smoothing capacitors, thus enabling to suppress a surge voltage at the time of turning off the power semiconductor elements. Consequently, an advantage also exists in that a power semiconductor element of low rated voltage can be used.

### Embodiment 5

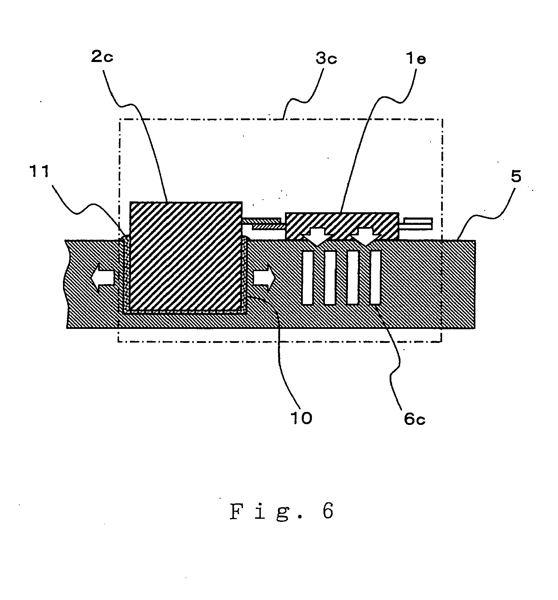

Fig. 6 is a partially cross sectional view of the structural diagram of power conversion equipment according to a fifth embodiment. The entire structural diagram is equal to that of the fourth embodiment. Fig. 6 shows a cross sectional view of the part corresponding to the cross sectional view taken along the line B-B of Fig. 5. Accordingly, other than the arrangement in this cross sectional view, the power conversion equipment according to the fifth embodiment is the same as that according to the fourth embodiment, so that descriptions of the same parts are omitted, and description is made with a focus on different points.

The power conversion equipment according to this fifth embodiment is constructed such that a gap is formed between a smoothing capacitor 2a and the concave part 10 formed in the cooling plate 5, and this gap is filled with a heat transfer grease 11. The gap is, for example, approximately 1 mm. In addition, although Fig. 6 shows a W-phase section as a representative example, the U-phase and the V-phase are also the same in construction.
As a result of such construction, heat that is generated at a smoothing capacitor 2 at the time of carrying current through the power conversion equipment, is transferred to the cooling plate 5 via the heat transfer grease 11, and cooled with the refrigerant flowing through a refrigerant channel 6 in the proximity as indicated by the thick arrows in the drawing.

As described above, according to the fifth embodiment of the invention, a gap is formed between the smoothing capacitor and the concave part formed in the cooling plate, and the gap is filled with heat transfer grease. As a result, it is possible to absorb the change in dimension caused by thermal expansion of a smoothing capacitor at the grease portion, as well as to make the contact heat resistance with the cooling plate smaller, thus enabling to achieve the higher cooling effect of a smoothing capacitor.

Additionally, in any invention according to the first to fifth embodiments described above, it is preferable to use one power semiconductor element in each phase, or to use not less than three power semiconductor elements connected in parallel. Further, although the case of groups being aligned in a single line is described, it is preferable to arrange two lines of groups alternately located in the same manner in case of a larger capacity.
Furthermore, although a power semiconductor element is described as IGBT, it is preferable to use also other switching elements such as a GTO or a transistor. In addition, although the case in which power conversion equipment is an inverter is described, it is preferable that the power conversion equipment is a converter.

### Industrial Applicability

The invention is power conversion equipment for use in, for example, electric vehicles, and is preferably applied to a cooling structure of a power conversion equipment in the case where power semiconductor elements are multi-packaged.

### Brief Description of Drawings

- Fig. 1: is a circuit schematic diagram of power conversion equipments according to first to fifth preferred embodiments of the present invention.
- Figs. 2: are structural diagrams of the power conversion equipment according to the first embodiment of the invention.
- Figs. 3: are structural diagrams of the power conversion equipment according to the second embodiment of the invention.
- Figs. 4: are structural diagrams of the power conversion equipment according to the third embodiment of the invention.
- Figs. 5: are structural diagrams of the power conversion equipment according to the fourth embodiment of the invention.
- Fig. 6: is a partially cross sectional view of structure of the power conversion equipment according to the fifth embodiment of the invention.

### Reference Signs

- 1a to 1f: = power semiconductor elements
- 2a to 2c: = smoothing capacitors
- 3a to 3c: = groups
- 5: = cooling plate
- 6a to 6c: = refrigerant channels
- 8: = auxiliary refrigerant channel
- 9: = connection channel
- 10: = concave part
- 11: = heat transfer grease

## Claims

1. A cooling structure of a power conversion equipment, which includes a power semiconductor element and a smoothing capacitor, and which makes the power conversion from DC to AC, or from AC to DC,
the cooling structure of a power conversion equipment being **characterized in that** the power semiconductor element is connected adjacent to one side of the smoothing capacitor to form a group; plural numbers of the groups are located on a cooling plate so that the power semiconductor elements and the smoothing capacitors are alternately aligned; and a refrigerant channel for cooling the power semiconductor and the smoothing capacitor is provided in the cooling plate immediately below the power semiconductor element.

2. The cooling structure of a power conversion equipment according to claim 1, wherein in the vicinity of the smoothing capacitor of the end group in which the smoothing capacitor is at the very end out of plural numbers of the groups, an auxiliary refrigerant channel is provided in the cooling plate positioned on the opposite side to the power semiconductor element of the end group.

3. The cooling structure of a power conversion equipment according to claim 2, wherein a connection channel for providing the connection between the refrigerant channels and the auxiliary refrigerant channel to combine the entire channels into one series passage is formed in the cooling plate.

4. The cooling structure of a power conversion equipment according to any one of claims 1 to 3, wherein the smoothing capacitor is fitted and fixed in a concave part formed in the cooling plate in conformity with the configuration of the smoothing capacitor.

5. The cooling structure of a power conversion equipment according to claim 4, wherein a gap is formed between the smoothing capacitor and the concave part, and the gap is filled with a heat transfer grease.
